# FASCICULE DE BREVET EUROPEEN

(11) **EP 0 524 112 B1**
(45) Date de publication et mention de la délivrance du brevet: **02.08.1995**
(21) Numéro de dépôt: 92420174.2
(22) Date de dépôt: 26.05.1992
(51) Int. Cl.: H01L 21/00, H05K 13/00

(54) **Embout notamment pour pipette à vide**
Spitze, insbesondere für Vakuumpipetten
Tip, in particular for a vacuum pipette

(30) Priorité: 20.06.1991 US 717964
(43) Date de publication de la demande: 20.01.1993
(73) Titulaire: RECIF S.A., 31840 Aussonne (FR)
(72) Inventeur: Poli, Bernard, F-31840 Aussonne (FR); Chincholle, Gerard, F-31500 Toulouse (FR)
(74) Mandataire: Dupuis, François

(56) Documents cités:
- WO-A-90/12977
- IBM TECHNICAL DISCLOSURE BULLETIN. vol. 30, no. 7, Décembre 1987, NEW YORK US page 62; 'electrostatic dissipative vacuum pencil'

## Description

L'invention se rattache au secteur technique de la fabrication des circuits intégrés. Plus particulièrement, l'invention concerne des outils sous vide, du type pipette, utilisés pour la manipulation de pastilles semiconducteurs, telles que les plaquettes de silicium.

En effet, lors de la fabrication des circuits intégrés, il est souvent nécessaire de saisir et de manipuler les pastilles semiconducteurs sur lesquelles sont fabriqués les circuits. Différents outils peuvent être utilisés dans ce but.

On peut utiliser par exemple, des pipettes à vide dont l'embout de préhension est décrit dans le brevet américain 4.981.315 appartenant au titulaire de la présente demande.

Bien que les embouts décrits dans ce brevet donnent satisfaction, il apparait cependant au moins un problème durant la fabrication des circuits intégrés, problème qui n'est pas résolu.

En effet, très souvent, au cours du processus de fabrication, les pastilles se chargent d'électricité statique, ce qui a pour conséquence d'attirer les particules au niveau du circiuit ayant la charge opposée. De telles particules, si elles sont effectivement en contact avec la pastille, peuvent détériorer les circuits en voie de formation sur la pastille, en provoquant diverses perturbations de fonctionnement.

Une mise à la terre des outils sous vide telles que les pipettes, est une technique connue qui permet d'éviter cet inconvénient. Toutefois, cette technique génère une brusque décharge statique, lorsque l'outil sous vide, normalement mis à la terre, vient en contact avec une pastille chargée, ce qui peut, là encore, provoquer des détériorations au niveau du circuit.

On peut citer également le document WO 90/12977 qui enseigne un dispositif de liaison entre le corps et l'embout d'une pipette à vide. Ce dispositif met en oeuvre un moyen apte à assurer l'évacuation des charges électrostatiques. Ce moyen, sous forme de cylindre réalisé en matériau conducteur, est disposé au niveau de l'accouplement de l'embout et du corps, de manière à être en contact avec une partie dudit corps et de l'embout.

Le problème que se propose de résoudre l'invention est de permettre, au niveau d'un embout de pipette à vide, la décharge d'électricité statique, sans pour autant créer des dommages au niveau des circuits en cours de formation sur la pastille.

Plus particulièrement l'invention s'applique à un embout pour pipette à vide, comprenant de manière connue, un moyen de raccordement pour son accouplement au corps de pipette et une zone de préhension avec une ouverture, pour l'application du vide au niveau de la pastille.

Pour résoudre un tel problème, l'embout comprend un manchon, avec deux extrémités, la première extrémité étant accouplée au moyen de raccordement, tandis que la deuxième extrémité est accouplée à la zone de préhension, ledit manchon, en matériau isolant, connectant électriquement la zone de préhension au moyen de raccordement par l'intermédiaire d'une résistance électrique de valeur ohmique élevée le manchon comprend un moyen de conduit intérieur en communication avec l'ouverture en étant accouplé au moyen de raccordement, pour communiquer le vide à ladite zone de préhension.

Compte-tenu de ces dispositions, il apparait, la résistance étant couplée à l'embout, que l'importante décharge électrostatique unitaire qui se produit lorsque les embouts sont utilisés avec des pastilles chargées, est réduite à une série de petites décharges. Chacune de ces décharges n'est pas suffisamment importante pour détériorer la pastille.

Avantageusement, la résistance à une valeur se situant dans une gamme de 10 à 50 MΩ.

Pour résoudre le problème posé de transporter le courant électrique, la zone de préhension et le moyen de raccordement se composent d'un matériau thermoplastique à l'intérieur duquel sont noyées des fibres conductrices pour le transport d'un courant électrique.

Plus particulièrement, le problème posé du transport et de la dissipation du courant électrique est résolu en ce que le manchon résistif se compose d'un matériau thermoplastique, à l'intérieur duquel est noyée la résistance électrique, ledit manchon résistif étant non conducteur de l'électricité, la résistance électrique étant reliée électriquement à la zone de préhension et au moyen de raccordement pour le transport et la dissipation d'un courant électrique.

Le matériau thermoplastique est sélectionné parmi les matériaux poly-éther-éther-cétone et poly-éther-cétone, les fibres conductrices étant sélectionnées parmi les fibres de carbone ou les fibres de carbure de silicium.

Le pourcentage des fibres de carbone est de l'ordre de 8 %.

Pour résoudre le problème posé de réduire au minimum la contamination chimique au niveau de l'embout, la zone de préhension est recouverte d'un revêtement céramique. Ce revêtement céramique est réalisé avec une conductivité controlée et peut contribuer au réglage de l'impédance de l'embout, pour permettre la décharge électrostatique des pastilles chargées.

Avantageusement, ce revêtement se compose de carbure de silicium, de bioxyde de silicium ou de silicium.

L'invention est exposée, ci-après plus en détail à l'aide des dessins annexés, dans lesquels :

La figure 1 est une vue en perspective et de dessus d'un embout de pipette selon l'invention.

Les figures 2a et 2b sont des vues en coupe du manchon résistif.

La figure 3 est un graphique montrant l'évolution de la tension par rapport au temps lorsque l'embout est utilisé pour la prise d'une pastille semi-conducteur.

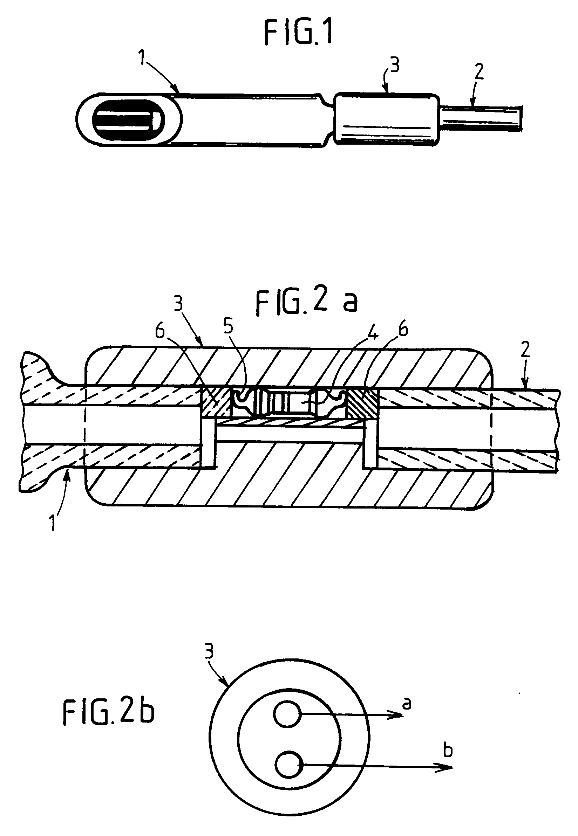

La figure 1 montre un embout pour pipette à vide du type de celui décrit dans le brevet américain précité 4.981.315. L'embout peut être réalisé dans un matériau poly-éther-éther-cétone (PEEK), poly-éthercétone (PEK) ou autres matériaux thermoplastiques ayant des caractéristiques similaires et dans lequel ont été mélangées des fibres conductrices se composant de carbone ou de carbure de silicium.

Dans une mise en oeuvre préférée, l'embout se compose de PEK mélangé avec des fibres de carbone. La proportion des fibres de carbone par rapport au PEK peut variée dans une gamme s'étendant de 5 à 12 %. D'une manière préférée, la proportion des fibres est de 8 %.

L'embout (1) est revêtu en totalité avec un revêtement céramique, pour éviter une contamination particulaire et ionique, à partir du PEK et des fibres de carbone. Etant donné que le PEK et les fibres contiennent des éléments tels que Na, K, Mg et Pb, la contamination, à partir de l'embout, peut constituer une source importante de contamination chimique pour les pastilles au moment de leur manipulation.

Ce revêtement se compose de SiC, SiO2 et de Si. Le revêtement est déposé, soit en utilisant la précipitation à froid de vapeurs chimiques, plasma, soit en utilisant un crépitement ou crachement réactif. Dans une mise en oeuvre préférée, on utilise une technique de crépitement réactif pour le revêtement de l'embout. On applique sur l'embout, une couche de quelques micromètres, dont l'épaisseur est avantageusement d'environ 10 micromètres.

Dans d'autres mises en oeuvre, le revêtement peut avoir une conductivité susceptible de remplacer l'impédance discontinue couplée à l'embout et décrite ci-après. De même, le revêtement peut être prévu moins conducteur que le matériau de base utilisé pour fabriquer l'embout. Lorsqu'on utilise ce type de revêtement, les décharges d'électricité statique se débiteront à travers le revêtement et dans le matériau de base de l'embout. De plus, le coefficient de friction du revêtement est peut élevé, ce qui réduit la possibilité de l'abrasion de la pastille.

L'embout (1) comprend, en outre, un manchon (3) et une partie de connexion (2) à la zone de préhension. Les figures 2a et 2b montrent la façon d'incorporer une résistance (4) de grande valeur au niveau de l'embout (1). Avantageusement, la résistance (4) à une valeur se situant dans une gamme de 10 à 50 MΩ.

Le manchon (3), de forme cylindrique présente deux passages axiaux (a) et (b). La résistance (4) est disposée dans le passage (b) et soudée à demeure à ses extrémités au moyen de petits cylindres (6) se composant de PEEK avec des fibres carbone noyées dans le PEEK. On réalise ainsi une liaison électrique à partir des cylindres (6) et traversant la résistance (4). En outre, le fil métallique de la résistance (4) étant obturé de manière positive, il ne peut pas contaminer les pastilles et ne sera pas affecté par des détergents chimiques, des solvants, etc...

Le passage (a) permet l'alimentation du vide dans le manchon (3). L'extrémité de l'embout (1) est emmanchée à l'une des extrémités du manchon (3), dont l'autre extrémité reçoit la partie de connexion (2) de la zone de préhension de la pipette. On établit aux points (5), le contact électrique de la résistance avec les petits cylindres (6).

Le manchon en PEEK (3) est un isolateur. Il en résulte que tout le courant se débitant à partir de l'embout se débitera dans la résistance (3) avant de passer sur la partie de connexion (2). Lorsque l'embout est inserré dans un outil sous vide, un fil métallique bobiné passant dans la source de vide dudit outil, relie l'embout à un potentiel de terre.

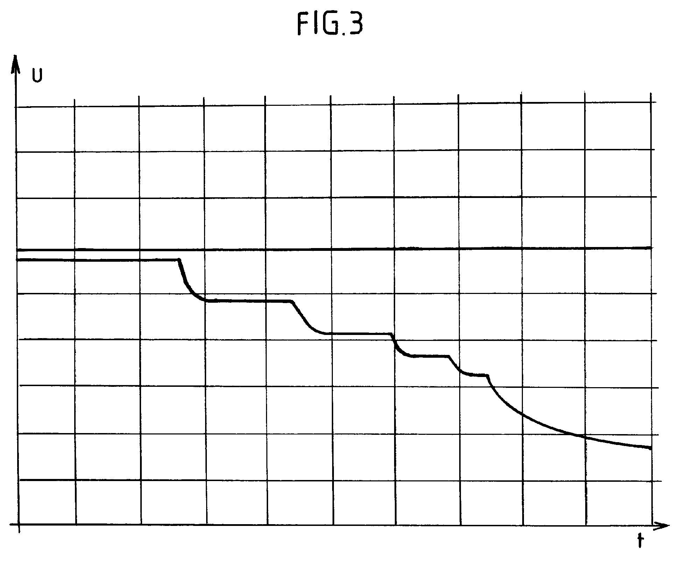

Comme le montre la figure 3, lorsqu'un embout incorporant le matériau spécial et la résistance spéciale selon l'invention est utilisé pour la préhension d'une pastille chargée, les décharges statiques individuelles constituent une série de petits chocs discontinus, chacun étant trop peu important pour détériorer la pastille.

La présente invention a été décrite avec une mise en oeuvre préférée, mais peut présenter de nombreuses variantes, notamment au niveau de la valeur de la résistance et de la nature des revêtements.

## Revendications

1. Embout pour pipette à vide notamment pour la manipulation de pastilles de semi-conducteurs, comprenant un moyen de raccordement (2) pour son accouplement au corps de pipette et une zone de préhension avec une ouverture pour l'application du vide au niveau de la pastille, caractérisé en ce que l'embout (1) comprend un manchon (3), avec deux extrémités, la première extrémité étant accouplée au moyen de raccordement (2), tandis que la deuxième extrémité est accouplée à la zone de préhension, ledit manchon, en matériau isolant, connectant électriquement la zone de préhension au moyen de raccordement par l'intermédiaire d'une résistance électrique (4) de valeur ohmique élevée ; le manchon (3) comprend un moyen de conduit intérieur (b) en communication avec l'ouverture en étant accouplé au moyen de raccordement (2), pour communiquer le vide à ladite zone de préhension.

2. Embout selon la revendication 1, caractérisé en ce que la résistance (4) à une valeur se situant dans une gamme de 10 à 50 MΩ.

3. Embout selon la revendication 1, caractérisé en ce que la zone de préhension et le moyen de raccordement (2) se composent d'un matériau thermoplastique à l'intérieur duquel sont noyées des fibres conductrices pour le transport d'un courant électrique.

4. Embout selon la revendication 3, caractérisé en ce que le manchon (3) se compose d'un matériau thermoplastique, à l'intérieur duquel est noyée la résistance électrique (4), ledit manchon (3) étant non conducteur de l'électricité, la résistance électrique (4) étant reliée électriquement à la zone de préhension et au moyen de raccordement pour le transport et la dissipation d'un courant électrique.

5. Embout selon la revendication 3, caractérisé en ce que le matériau thermoplastique est sélectionné parmi les matériaux poly-éther-éthercétone et poly-éther-cétone, les fibres conductrices étant sélectionnées parmi les fibres de carbone ou les fibres de carbure de silicium.

6. Embout selon la revendication 5, caractérisé en ce que le pourcentage des fibres de carbone est de l'ordre de 8%.

7. Embout selon la revendication 1, caractérisé en ce que la zone de préhension est recouverte d'un revêtement céramique pour réduire au minimum la contamination chimique.

8. Embout selon la revendication 7, caractérisé en ce que le revêtement se compose de carbure de silicium, de bioxyde de silicium ou de silicium.

9. Embout selon la revendication 8, caractérisé en ce que le revêtement est formé en utilisant un crépitement réactif, le revêtement en résultant ayant une épaisseur de plusieurs micromètres.

10. Embout selon la revendication 8, caractérisé en ce que le revêtement est apte à dissiper l'électricité statique.

## Claims

1. Tip for suction pipette used, in particular, to handle semiconductor chips, comprising a means of connection (2) to fit it to the body of the pipette and a pick-up area with an opening in order to apply the vacuum to the chip characterised in that the tip (1) comprises a sleeve (3) having two ends, the first end being connected to means of connection (2) whereas the second end is connected to the pick-up area, said sleeve being made of an insulating material and providing electrical connection between the pick-up area and the means of connection via an electrical resistor (4) having a high resistive value; sleeve (3) comprises an inner duct (b) that communicates with the opening and is connected to means of connection (2) in order to apply the vacuum to said pick-up area.

2. Tip as claimed in claim 1 characterised in that the resistor (4) has a value in the range 10 to 50 MΩ.

3. Tip as claimed in claim 1 characterised in that the pick-up area and means of connection (2) are made of a thermoplastic material in which electrically conducting fibres are embedded in order to carry an electric current.

4. Tip as claimed in claim 3 characterised in that sleeve (3) is made of a thermoplastic material in which the electrical resistor (4) is embedded, said sleeve (3) not being an electrical conductor and electrical resistor (4) being electrically connected to the pick-up area and to the means of connection in order to carry and dissipate an electric current.

5. Tip as claimed in claim 3 characterised in that the thermoplastic material is selected from polyether ethercetone and polyether cetone materials and the electrically conductive fibres are selected from carbon or silicon carbide fibres.

6. Tip as claimed in claim 5 characterised in that the percentage of carbon fibres is of the order of 8%.

7. Tip as claimed in claim 1 characterised in that the pick-up area is covered with a ceramic coating in order to minimise chemical contamination.

8. Tip as claimed in claim 7 characterised in that the coating consists of silicon carbide, silicon dioxide or silicon.

9. Tip as claimed in claim 8 characterised in that the coating is formed by using reactive spluttering and the resulting coating has a thickness of several micrometres.

10. Tip as claimed in claim 8 characterised in that the coating is capable of eliminating electrostatic charging.

## Patentansprüche

1. Aufsatz für Vakuumpipetten, insbesondere für die Handhabung von Halbleiterchips, mit einer Anschlußvorrichtung (2) für die Ankoppelung an den Pipettenkörper und mit einem Griffbereich mit einer Öffnung zum Schaffen des Vakuums im Bereich des Chips, dadurch gekennzeichnet, daß der Aufsatz (1) eine Muffe (3) mit zwei Enden umfaßt, wobei das erste Endstück an die Anschlußvorrichtung (2) angekoppelt ist, während das zweite Endstück mit dem Griffbereich verbunden ist; die Muffe aus Isoliermaterial sorgt für die elektrische Verbindung zwischen dem Griffbereich und der Anschlußvorrichtung über einen hochohmigen elektrischen Widerstand (4); die Muffe (3) umfaßt eine innere Leitung (b), die mit der Öffnung in Verbindung steht, wobei sie an die Anschlußvorrichtung (2) angekoppelt ist, um das Vakuum auf den besagten Griffbereich zu übertragen.

2. Aufsatz nach Anspruch 1, dadurch gekennzeichnet, daß der Widerstandswert (4) zwischen 10 und 50 MΩ beträgt.

3. Aufsatz nach Anspruch 1, dadurch gekennzeichnet, daß der Griffbereich und die Anschlußvorrichtung (2) aus einem thermoplastischen Material bestehen, in dem leitende Fasern für den Transport eines elektrischen Stroms vergossen sind.

4. Aufsatz nach Anspruch 3, dadurch gekennzeichnet, daß die Muffe (3) aus einem thermoplastischen Material besteht, in dem der elektrische Widerstand (4) vergossen ist, wobei die Muffe (3) keinen Strom leitet und der elektrische Widerstand (4) elektrisch mit dem Griffbereich und der Anschlußvorrichtung für den Transport und die Dissipation eines elektrischen Stroms in Verbindung steht.

5. Aufsatz nach Anspruch 3, dadurch gekennzeichnet, daß das thermoplastische Material aus den Werkstoffen Polyetheretherketon und Polyetherketon ausgewählt wird, während die stromleitenden Fasern aus Karbonfasern oder aus Siliziumkarbidfasern bestehen.

6. Aufsatz nach Anspruch 5, dadurch gekennzeichnet, daß der Anteil der Karbonfasern ca. 8% beträgt.

7. Aufsatz nach Anspruch 1, dadurch gekennzeichnet, daß der Griffbereich mit einer Keramikschicht überzogen ist, um die chemische Kontamination weitgehend einzuschränken.

8. Aufsatz nach Anspruch 7, dadurch gekennzeichnet, daß der Überzug aus Siliziumkarbid, Siliziumbioxid oder Silizium besteht.

9. Aufsatz nach Anspruch 8, dadurch gekennzeichnet, daß der Überzug durch reaktives Spratzen gebildet wird, wobei die resultierende Schicht mehrere Mikrometer dick ist.

10. Aufsatz nach Anspruch 8, dadurch gekennzeichnet, daß der Überzug geeignet ist, die statische Elektrizität abzuführen.
